# EUROPEAN PATENT APPLICATION

(11) **EP 4 733 333 A1**
(43) Date of publication of application: **29.04.2026**
(21) Application number: 23960660.1
(22) Date of filing: 20.12.2023
(51) Int. Cl.: C08F 210/16, C08F 210/14, C08F 210/08, C09J 7/30, C09J 123/08, H10F 19/80

(54) **ETHYLENE/ALFA-OLEFIN COPOLYMER AND APPLICATION THEREOF, AND PACKAGING ADHESIVE FILM COMPOSITION**

(30) Priority: 04.12.2023 CN 202311638449
(71) Applicant: Wanhua Chemical Group Co., Ltd., Yantai, Shandong 264006 (CN)
(72) Inventor: WANG, Jinqiang, Yantai, Shandong 264006 (CN); YANG, Ying, Yantai, Shandong 264006 (CN); LUO, Kexin, Yantai, Shandong 264006 (CN); ZHANG, Yanyu, Yantai, Shandong 264006 (CN); JIAO, Dong, Yantai, Shandong 264006 (CN); LIN, Xiaojie, Yantai, Shandong 264006 (CN); WANG, Dalin, Yantai, Shandong 264006 (CN)
(74) Representative: Potter Clarkson
(86) International application number: PCT/CN2023/140206
(87) International publication number: WO 2025/118352

(57) **Abstract**

The present application relates to the technical field of olefin polymerization, and in particular to an ethylene/α-olefin copolymer and an application thereof, and a packaging adhesive film composition. The ethylene/α-olefin copolymer has the following characteristics: (a) the melting peak temperature measured by means of a differential scanning calorimeter (DSC) is 30-90°C, and the melting range width measured by means of the DSC is 75-90°C; and (b) dH(90) and dH(100) continuously measured by using the DSC and from nucleation/annealing (SSA), wherein 0 ≤ dH(90) ≤ 2J/g, and dH(100) = 0. The ethylene/α-olefin copolymer of the present application has specific property characteristics, and when the polymer is used in an adhesive film processing process, a high degree of crosslinking is still maintained while the mixing time of the polymer and an auxiliary agent is shortened.

## Description

### TECHNICAL FIELD

The present application pertains to the technical field of olefin polymerization, specifically to an ethylene/α-olefin copolymer and application thereof, as well as a packaging adhesive film composition.

### BACKGROUND

Polyolefins constitute the largest proportion of polymer materials, characterized by low cost, light specific weight, and ease of processing and molding. Among them, ethylene/α-olefin copolymers exhibit the plasticity of plastics and the high elasticity of rubber, making them one of the main directions for the development of high-end polyolefin materials.

As global environmental issues and energy problems become increasingly severe, solar cells have garnered attention as a means of energy generation that does not require concern for environmental pollution or depletion. If solar cells are intended for outdoor use (such as on the roof of a building), modular solar cells are typically employed. When manufacturing solar cell modules, in order to obtain crystalline solar cell modules, the front glass, solar cell encapsulation agent, crystalline solar cell device, solar cell encapsulation agent, and back glass or back protective sheet are sequentially stacked. As encapsulation agents for solar cells, ethylene/vinyl acetate copolymers or ethylene/α-olefin copolymers, which exhibit excellent transparency, flexibility, and adhesion, are commonly used.

Due to their excellent resistance to PID, ethylene/α-olefin copolymers have gradually become the mainstream and future development direction of photovoltaic cell encapsulation. When ethylene/α-olefin copolymers are prepared into photovoltaic adhesive films, crosslinking auxiliary agents are generally added to enhance their mechanical strength and heat resistance. However, the low affinity between the polar materials used for crosslinking (such as crosslinking agents and crosslinking auxiliary agents) and ethylene/α-olefin copolymers can easily lead to insufficient crosslinking degree or prolonged mixing time during the addition of auxiliary agents, which affects processing efficiency and limits the application of ethylene/α-olefin copolymers in the field of photovoltaic encapsulation.

Therefore, there is a need for the continuous development of ethylene/α-olefin copolymers with special properties to meet the application requirements in the field of photovoltaic encapsulation.

### SUMMARY OF THE INVENTION

The following is an overview of the subject matter described in detail in the present application. This overview is not intended to limit the scope of protection of the claims.

To address some issues encountered in the application of ethylene/α-olefin copolymers in the field of photovoltaic encapsulation, the present application provides an ethylene/α-olefin copolymer, application thereof, and a packaging adhesive film composition. The ethylene/α-olefin copolymer possesses specific performance characteristics that can meet the application requirements of photovoltaic adhesive films. It can solve the problems of long mixing time of auxiliary agents during adhesive film processing or insufficient crosslinking degree, and has good industrial prospects.

In the first aspect, an ethylene/α-olefin copolymer is provided, which has the following characteristics:
(a) a melting peak temperature ranging from 30°C to 90°C (e.g., 35°C, 40°C, 45°C, 50°C, 55°C, 60°C, 65°C, 70°C, 75°C, 80°C), and a melting range width ranging from 75°C to 90°C (e.g., 78°C, 80°C, 82°C, 84°C, 85°C, 88°C, 89°C), as measured by DSC; and
(b) dH(90) and dH(100) as measured by successive self-nucleation/annealing (SSA) using a differential scanning calorimetry, wherein 0 ≤ dH(90) ≤ 2J/g (e.g., 0.01J/g, 0.05J/g, 0.1J/g, 0.2J/g, 0.4J/g, 0.5J/g, 0.8J/g, 1.0J/g, 1.2J/g, 1.5J/g, 1.8J/g), and dH(100) = 0.

The melting range of a polymer is a temperature interval, which is referred to as the melting range interval; the two limits are respectively called the initial melting temperature and the final melting temperature. The initial melting temperature is the temperature at which the substance begins to melt, and the final melting temperature is the temperature at which the substance is completely melted. In the present application, the melting range width is defined as the difference between the temperature at which the polymer is completely melted and the temperature at which it begins to melt, that is, the difference between T_{endset} and Tₒₙₛₑₜ.

In the present application, when the heat capacity of each segment is graded relative to the total heat capacity by integrating the temperature-heat capacity curve of each segment in the SSA measurement results obtained using a differential scanning calorimeter, dH(90) represents the sum of melting enthalpies above 90°C, and dH(100) represents the sum of melting enthalpies above 100°C.

According to the ethylene/α-olefin copolymer provided in the present application, in some embodiments, the ethylene/α-olefin copolymer further has the following characteristics:
(c) a density ranging from 0.850 g/cm³ to 0.905 g/cm³, for example, 0.852 g/cm³, 0.855 g/cm³, 0.86 g/cm³, 0.87 g/cm³, 0.88 g/cm³, 0.89 g/cm³, 0.90 g/cm³, and 0.904 g/cm³; and
(d) a weight-average molecular weight ranging from 20,000 g/mol to 150,000 g/mol (e.g., 25,000 g/mol, 30,000 g/mol, 50,000 g/mol, 60,000 g/mol, 80,000 g/mol, 100,000 g/mol, 120,000 g/mol, 140,000 g/mol), and a polymer dispersity index PDI ranging from 2.3 to 3 (e.g., 2.35, 2.4, 2.5, 2.6, 2.8, 2.9, 2.95).

In some embodiments, the melting enthalpy of the ethylene/α-olefin copolymer ranges from 20 J/g to 100 J/g, for example, 22 J/g, 25 J/g, 30 J/g, 40 J/g, 50 J/g, 60 J/g, 80 J/g, 90 J/g, and 95 J/g.

In some embodiments, the ethylene/α-olefin copolymer has a melt index (MI) ranging from 0.1 g/10min to 30 g/10 min, for example, 0.2 g/10 min, 0.5 g/10 min, 1.0 g/10 min, 2.0 g/10 min, 5.0 g/10 min, 8.0 g/10 min, 10 g/10 min, 12 g/10 min, 15 g/10 min, and 18 g/10 min, at 190°C and a load of 2.16 kg.

In some embodiments, the glass transition temperature (Tg) of the ethylene/α-olefin copolymer ranges from -65°C to -30°C, for example, -62°C, -60°C, -55°C, -50°C, -45°C, -40°C, -38°C, -35°C, and -32°C.

In some embodiments, in the ethylene/α-olefin copolymer, the α-olefin is a C3-C20 olefin or a mixture thereof.

In some embodiments, the α-olefin is one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, and 1-eicosene.

In some embodiments, the ethylene/α-olefin copolymer is a product obtained by solution polymerization reaction of ethylene with one or more α-olefins in the presence of a catalyst and optionally hydrogen as a chain transfer agent.

In some embodiments, the solution polymerization reaction is carried out in one or more polymerization reactors.

In some embodiments, the polymerization reactor is one or more of a non-stirred or stirred cylindrical container, a tank-shaped container, and a circulation loop reactor.

In some embodiments, when the polymerization reactor is a cylindrical container, a length-to-diameter ratio of the cylindrical container ranges from 2:1 to 3:1 (e.g., 2.1:1, 2.2:1, 2.4:1, 2.5:1, 2.8:1); when the polymerization reactor is a tank-shaped container, a length-to-diameter ratio of the tank-shaped container ranges from 2:1 to 3:1 (e.g., 2.1:1, 2.2:1, 2.4:1, 2.5:1, 2.8:1); and when the polymerization reactor is a circulation loop reactor, the cycle ratio of the circulation loop reactor ranges from 20 to 40 (e.g., 22, 24, 25, 26, 28, 30, 32, 35, 38).

In polymerization reactions, the length-to-diameter ratio or cycle ratio of the reactor can lead to temperature and concentration distributions of the materials entering the reactor. Therefore, the relevant characteristics of the obtained polymer can be regulated by adjusting the length-to-diameter ratio or cycle ratio of the reactor. Of course, it is not excluded that there may be other means to regulate the relevant characteristics of the obtained polymer. For example, by controlling the length-to-diameter ratio and cycle ratio of the reactor, the temperature and concentration distributions within the reaction system can be adjusted, thus achieving the regulation of ethylene content, comonomer content, and temperature in micro-regions. This further allows for the adjustment of catalyst reactivity ratios in different temperature zones within the micro-regions, ultimately enabling the production of polymers with specific properties, such as melting range width, dH(90), and dH(100).

During the solution polymerization process, a solvent is also present. The solvent is in a liquid or supercritical state under the polymerization conditions. The solvent may be a hydrocarbon solvent. For example, the liquid hydrocarbon solvents used may optionally be C5-C12 hydrocarbon compounds, such as hydrocarbons that are unsubstituted or substituted with C1-C4 alkyl groups (e.g., pentane, methyl pentane, hexane, C6 mixed alkanes, cyclohexane, methylcyclohexane, heptane, octane, hydrogenated naphtha). Optionally, it may be one or more selected from the group consisting of hexane, C6 mixed alkanes, methylcyclohexane, and IsoparE.

In some embodiments, during the solution polymerization reaction, the catalyst comprises a main catalyst and a co-catalyst.

In some embodiments, the main catalyst is a homogeneous catalyst selected from metallocene catalysts or non-metallocene catalysts.

In some embodiments, the main catalyst may be selected from, but not limited to, one or more of the following: silyl(N-tert-butylamino)(tetramethylcyclopentadienyl)titanium dichloride, dimethylsilyl(N-tert-butylamino)(tetramethylcyclopentadienyl)titanium dimethyl, dimethylsilyl(N-tert-butylamino)(fluorenyl)titanium dichloride, pentamethylcyclopentadienyltitanium trimethoxide, diphenylmethylidene(cyclopentadienyl)(9-fluorenyl)zirconium dichloride, dimethyldimethylsilylbis(2-methyl-4-phenyl-1-indenyl)zirconium dichloride, meso-dimethylsilylbis(1-indenyl)zirconium dichloride, bis(methylcyclopentadienyl)zirconium dichloride, bis(1,3-dimethylcyclopentadienyl)zirconium dichloride, trichloro(cyclopentadienyl)(1,2-dimethoxyethane)zirconium, diphenylsilyl(cyclopentadienyl)(9-fluorenyl)zirconium dichloride, rac-dimethylsilylenebis(2-methylindenyl) zirconium dichloride, [1-(η5-cyclopentadien-1-yl)-1-(η5-2,7-di-tert-butylfluoren-9-yl)-1,1-diphenylmethane]zirconium dichloride, di(p-tolyl)methylene(η5-cyclopentadienyl){η5-(2,7-ditert-butylfluorenyl)}zirconium dichloride, dimethylbis(propylcyclopentadienyl)hafnium, bis(n-butyl cyclopentadiene) hafnium dichloride, (dimethylsilylene)bis(2-methyl-4-phenylindenyl)zirconium dichloride, and compounds represented by formulas (I) to (VIII) below; 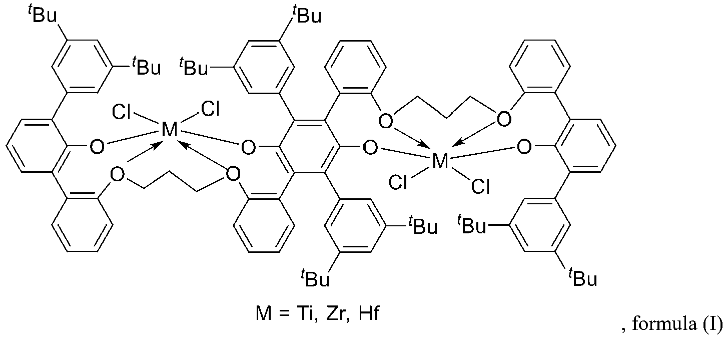 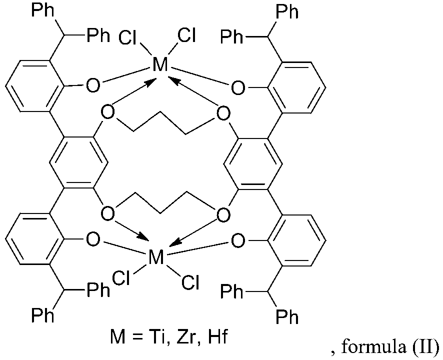 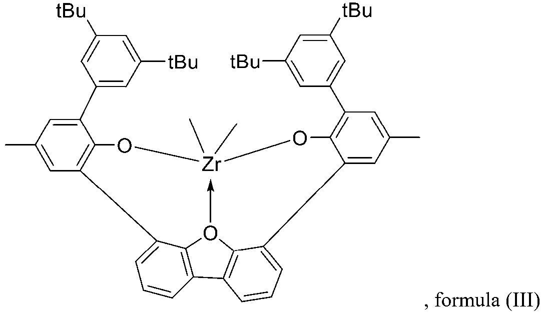 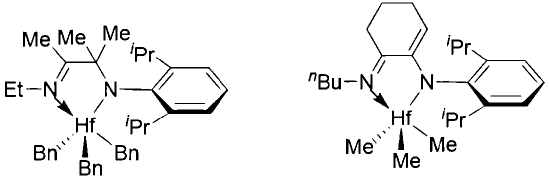 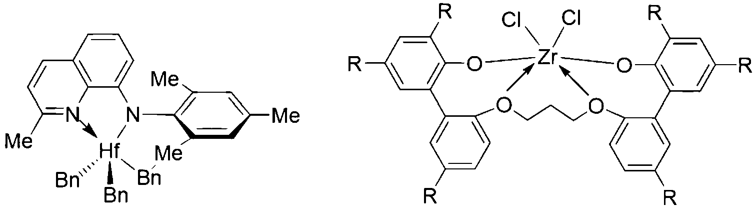 R is a C1-C30 alkyl, aryl, etc. , from left to right and from top to bottom, they are formula (IV) to formula (VIII) in sequence.

In some embodiments, the co-catalyst is one or more of aluminoxane, alkyl aluminum compound, and alkylaluminum chloride, or a composition comprising one or more of aluminoxane, alkyl aluminum compound, and alkylaluminum chloride, in combination with one or more organic borides; for example, the co-catalyst is a composition of aluminoxane and organic borides, a composition of alkyl aluminum compound and organic borides, or a composition of alkylaluminum chloride and organic borides.

In some embodiments, the aluminoxane is selected from the group consisting of methylaluminoxane (MAO) and modified methylaluminoxane (MMAO).

In some embodiments, the alkyl aluminum compound is selected from the group consisting of triethylaluminum, triisobuthylaluminum, and trioctylaluminum.

In some embodiments, the alkylaluminum chloride is selected from the group consisting of diethylaluminum chloride, sesquiethylaluminum chloride, and aluminium ethyl dichloride.

In some embodiments, the organic boride is selected from the group consisting of triphenylmethylium tetrakis(perfluorophenyl)borate, tri(pentafluorophenyl)borane, N,N-dimethylanilinium tetra(pentafluorophenyl)borate, dioctadecylmethylamine tetra(pentafluorophenyl)borate, and di(hydrogenated tallow) methyl amine tetra(pentafluorophenyl)borate.

Furthermore, the molar ratio of metal aluminum in the co-catalyst to metal M in the main catalyst, Al/M, ranges from 3 to 1,000, for example, it may be 5, 10, 20, 50, 80, 100, 120, 140, 160, 180, 200, 300, 400, 500, 600, 700, 800, or 900, and optionally 10 to 100.

Furthermore, the molar ratio of the organic boride (on a boron basis) in the co-catalyst to the metal M in the main catalyst, B/M, ranges from 0 to 10, for example, it may be 0, 1, 1.5, 2, 2.5, 3, 3.5, 4, 4.5, 5, 6, 7, 8, 9, 9.5, etc., and optionally 1 to 3.

In some embodiments, the solution polymerization reaction is conducted at 2 MPa to 10 MPa (e.g., 2.5 MPa, 3.0 MPa, 3.5 MPa, 4.0 MPa, 5.5 MPa, 6.0 MPa, 7.0 MPa, 8.0 MPa, 9.0 MPa), optionally at 2 MPa to 5 MPa.

In some embodiments, the reaction temperature for the solution polymerization reaction ranges from 100°C to 220°C, such as 110°C, 120°C, 140°C, 150°C, 180°C, 200°C, and 210°C.

In the present application, ethylene/α-olefin copolymers can be prepared through conventional polymerization processes in the field. For example, in solution polymerization reactions, the related process conditions and equipment can also be conventional choices in the field, which will not be further elaborated here.

In the second aspect, application of the ethylene/α-olefin copolymer as described above in the field of photovoltaic packaging adhesive films is provided.

The application of the ethylene/α-olefin copolymer in the field of photovoltaic adhesive films can be achieved through conventional operations in this field, which will not be elaborated here.

For example, the ethylene/α-olefin copolymer can be used to prepare cast films in the field of photovoltaic adhesive films through a casting process.

For example, the present application provides a composition for encapsulation agent film comprising the ethylene/α-olefin copolymer, which can be used to obtain a cast photovoltaic adhesive film after casting processing; alternatively, the composition for encapsulation agent film can also be used to prepare a modified resin composition (such as a silane-modified resin composition or an aminosilane-modified resin composition).

In the third aspect, a packaging adhesive film composition for a solar cell is provided, comprising: the ethylene/α-olefin copolymer as described above and optionally, an auxiliary agent.

According to the composition provided in the present application, in some embodiments, the ethylene/α-olefin copolymer has the following characteristics:
(a) a melting peak temperature ranging from 30°C to 90°C and a melting range width ranging from 75°C to 90°C, as measured by DSC; and
(b) dH(90) and dH(100) as measured by successive self-nucleation/annealing (SSA) using a differential scanning calorimetry, wherein 0 ≤ dH(90) ≤ 2J/g and dH(100) = 0.

The ethylene/α-olefin copolymer further has the following characteristics:
(c) a density ranging from 0.850 g/cm³ to 0.905 g/cm³; and
(d) a weight-average molecular weight ranging from 20,000 g/mol to 150,000 g/mol, and a polymer dispersity index (PDI) ranging from 2.3 to 3.

The ethylene/α-olefin copolymer has a melting enthalpy ranging from 20 J/g to 100 J/g; a melt index (MI) ranging from 0.1 g/10min to 30g/10min under conditions of 190°C and a load of 2.16kg; and a glass transition temperature Tg ranging from -65°C to -30°C.

Of course, the packaging adhesive film composition for solar cells provided in the present application can also include other additional components permitted in the field.

According to the composition provided in the present application, in some embodiments, the auxiliary agent is one or more selected from the group consisting of a crosslinking agent, a co-crosslinking agent, a coupling agent, and an antioxidant.

Furthermore, the crosslinking agent may be a peroxide-based crosslinking agent, including but not limited to one or a combination of the following compounds: tert-butylperoxy isopropyl carbonate, 2,5-dimethyl-2,5-(di-tert-butylperoxy)hexane, tert-butyl peroxy-2-ethylhexanoate, 1,1-bis(tert-butylperoxy)-3,3,5-trimethylcyclohexane, 1,1-bis(tert-amylperoxy)-3,3,5-trimethylcyclohexane, 1,1-bis(tert-amylperoxy)-3,3,5-trimethylcyclohexane, 1,1-bis(tert-amylperoxy)cyclohexane, 1,1-bis(tert-butylperoxy)cyclohexane, 2,2-bis(tert-butylperoxy)butane, tert-butylperoxy-2-ethylhexylcarbonate, tert-amylperoxy 2-ethylhexyl carbonate, tert-amylperoxy carbonate, and tert-butyl 3,3,5-trimethylperoxyhexanoate. Based on 100 parts by weight of ethylene/α-olefin copolymer, the amount of the crosslinking agent may be 0.1 to 5 parts by weight (e.g., 0.15 parts by weight, 0.2 parts by weight, 0.4 parts by weight, 0.6 parts by weight, 1.0 parts by weight, 1.5 parts by weight, 1.8 parts by weight, 2.2 parts by weight, 2.5 parts by weight, 3.0 parts by weight, 4.0 parts by weight), and optionally 0.5 to 2 parts by weight.

Furthermore, the co-crosslinking agent may be one or a combination of more of multifunctional acrylic ester substances, including but not limited to one or a combination of more of the following compounds: triallyl isocyanurate, trimethylolpropane triacrylate, trimethylolpropane trimethacrylate, pentaerythritol triacrylate, tris(2-hydroxyethyl) isocyanurate triacrylate, ethoxylated trimethylolpropane triacrylate, propoxylated trimethylolpropane triacrylate, ethoxylated glyceryl triacrylate, propoxylated glyceryl triacrylate, pentaerythritol tetraacrylate, ethoxylated pentaerythritol tetraacrylate, trimethylolpropane tetraacrylate, di(trimethylolpropane) tetraacrylate, di(trimethylolpropane) tetramethacrylate, propoxylated pentaerythritol tetraacrylate, tricyclodecanedimethanol diacrylate, propoxylated neopentyl glycol diacrylate, ethoxylated bisphenol A diacrylate, ethoxylated bisphenol A dimethacrylate, 2-butyl-2-ethyl-1,3-propanediol diacrylate, diethylene glycol dimethacrylate, triethylene glycol dimethacrylate, and polyethylene glycol dimethacrylate. Based on 100 parts by weight of ethylene/α-olefin copolymer, the amount of the co-crosslinking agent may be 0.1 to 5 parts by weight (e.g., 0.15 parts by weight, 0.2 parts by weight, 0.4 parts by weight, 0.6 parts by weight, 1.0 parts by weight, 1.5 parts by weight, 1.8 parts by weight, 2.2 parts by weight, 2.5 parts by weight, 3.0 parts by weight, 4.0 parts by weight), and optionally 0.1 to 2 parts by weight.

Furthermore, the coupling agent may be a silane-based coupling agent, including but not limited to one or a combination of more of the following compounds: γ -methacryloxy propyl trimethoxysilane, γ-chloropropylmethoxysilane, vinyl ethoxysilane, γ-(2,3-epoxypropoxy)propyltrimethoxysilane, tris(β-methoxyethoxy)(vinyl)silane, γ-methacryloxy propyl trimethoxysilane, vinyltriacetoxysilane, γ-glycidoxypropyltrimethoxysilane, 3-(trimethoxysilyl)propyl-2-methyl-2-acrylate, anilinomethyltriethoxysliane and octyltrimethoxysilane. Based on 100 parts by weight of the ethylene/α-olefin copolymer, the amount of the coupling agent may be 0.1 to 3 parts by weight (e.g., 0.15 parts by weight, 0.2 parts by weight, 0.4 parts by weight, 0.5 parts by weight, 1.0 parts by weight, 1.5 parts by weight, 1.8 parts by weight, 2.2 parts by weight, 2.5 parts by weight, 2.8 parts by weight), and optionally 0.1 to 0.6 parts by weight.

Furthermore, the antioxidant may be one or a combination of more of hindered phenolic antioxidants and phosphate ester antioxidants, including but not limited to one or a combination of more of the following compounds: n-octadecyl-β-(3,5-di-tert-butyl-4-hydroxyphenyl)-propionate, pentaerythritol tetra[β-(3,5-di-tert-butyl-4-hydroxyphenyl)propionate], bis(3,5-di-tert-butyl-4-hydroxypropionyl) hydrazine, 2,2'-oxamido-bis[ethyl-3-(3,5-di-tert-butyl-4-hydroxyphenyl)] propionate, N,N'-hexamethylene-bis(3,5-di-tert-butyl-4-hydroxyphenyl propionamide), 1,3,5-tris(3,5-di-tert-butyl-4-hydroxybenzyl)-1,3,5-triazine-2,4,6(1H,3H,5H) trione, triethylene glycol bis[3-(3-tert-butyl-5-methyl-4-hydroxyphenyl) propionate], 2-methyl-4,6-bis(octylsulfanylmethyl)phenol, tris[2,4-di-tert-butylphenyl] phosphite, bis[2,4-di-tert-butylphenyl] pentaerythritol diphosphite, and bis(2,6-di-tert-butyl-4-methylphenyl) pentaerythritol diphosphate. Based on 100 parts by weight of ethylene/α-olefin copolymer, the amount of the antioxidant may be 0.01 to 1 part by weight (e.g., 0.015 parts by weight, 0.02 parts by weight, 0.04 parts by weight, 0.05 parts by weight, 0.1 parts by weight, 0.15 parts by weight, 0.18 parts by weight, 0.2 parts by weight, 0.25 parts by weight, 0.3 parts by weight, 0.4 parts by weight, 0.55 parts by weight, 0.6 parts by weight, 0.8 parts by weight, 0.9 parts by weight), optionally 0.05 to 0.5 parts by weight.

In some embodiments, based on 100 parts by weight of ethylene/α-olefin copolymer, the packaging adhesive film composition for solar cells comprises the following components in the following amounts:
100 parts by weight of ethylene/α-olefin copolymer,
0.1 to 5 parts by weight of crosslinking agent, optionally 0.5 to 2 parts by weight;
0.1 to 5 parts by weight of co-crosslinking agent, optionally 0.1 to 2 parts by weight;
0.1 to 3 parts by weight of coupling agent, optionally 0.1 to 0.6 parts by weight; and
0.01 to 1 parts by weight of antioxidant, optionally 0.05 to 0.5 parts by weight.

The present application further provides a method for preparing the solar cell packaging adhesive film, which includes the following steps: weighing the raw material components in the composition according to the formulation, mixing and melting them, followed by extruding and granulating through an extruder, casting into a film, and subsequently cooling and slitting; the preparation method may further include a winding process. The specific operation, equipment used, and process conditions of this preparation method can be carried out with reference to conventional methods in the field, with no particular limitations imposed in this regard.

The ethylene/α-olefin copolymer described in the present application, due to its wide melting range, 0 ≤ dH(90) ≤ 2J/g, and dH(100) = 0, contains more rubber phase (non-crystalline phase) in the system. Therefore, when melt-mixed with other auxiliary agents, auxiliary agents such as crosslinking agents are more likely to penetrate into the particles. Consequently, under the same auxiliary agent absorption time, more auxiliary agents migrate into the particles, making it easier to achieve auxiliary agent absorption when processing compositions containing ethylene/α-olefin copolymer and auxiliary agents. Additionally, when the composition undergoes further crosslinking, the resulting polymer/composition exhibits a higher degree of crosslinking, thus displaying stronger mechanical properties. Furthermore, when controlling for the same degree of crosslinking, the auxiliary agent absorption time required for the composition particles described in the present application is shorter.

Compared with related technologies, the excellent effect of the technical solution of the present application lies at least in:
The ethylene/α-olefin copolymer described in the present application exhibits unique performance characteristics, including a broad melting range, 0 ≤ dH(90) ≤2J/g, and dH(100) = 0. When processing compositions containing ethylene/α-olefin copolymer and auxiliary agents, it is easier to achieve absorption of the auxiliary agents, resulting in shorter absorption time required for the composition particles. Simultaneously, further crosslinking leads to a higher degree of crosslinking in the resulting product. Compositions containing ethylene/α-olefin copolymer and auxiliary agents is capable of meeting the application requirements for photovoltaic adhesive films and can address issues of long mixing time for auxiliary agents or insufficient crosslinking during adhesive film processing, offering promising prospects for industrial-scale application.

After reading and understanding the detailed description, other aspects will become apparent.

### DETAILED DESCRIPTION

To gain a detailed understanding of the technical features and content of the present application, the following will provide a more comprehensive description of its alternative embodiments. Although the embodiments described in the examples illustrate alternative embodiments of the present application, it should be understood that the present application can be realized in various forms and should not be limited by the embodiments presented here.

Unless otherwise specified, the experimental procedures used in the following examples are conventional methods.

The materials, reagents, etc. used in the following examples can be obtained from commercial sources, and the specific information of some raw materials is as follows:
8660, ethylene/octene copolymer, purchased from Dow;
8688, ethylene/butylene copolymer, purchased from Dow;
IsoparE, 100% hydrogenated naphtha, purchased from Mobil;
Ethylene, polymerization grade, purchased from Air Liquide;
1-Octene, 98%, purchased from INEOS;
1-Hexene, 99%, purchased from Lingyan Biotech;
1-Butene, 99%, purchased from Mingju;
Dimethylsilyl(N-tert-butylamino)(fluorenyl)titanium dichloride, 99%, Strem, labeled as M1;
Dimethylsilyl(N-tert-butylamino)(tetramethylcyclopentadienyl)titanium dimethyl, 99%, purchased from Sinocompound, labeled as M2;
[1-(η5-cyclopentadien-1-yl)-1-(η5-2,7-di-tert-butylfluoren-9-yl)-1,1-diphenylmethane]zirconium dichloride, 98%, purchased from Honor Shine Chemical, labeled as M3;
The compound (labeled as M4) was synthesized according to Example 6 in patent document CN 114315883 A, and its chemical structural formula is shown as follows: 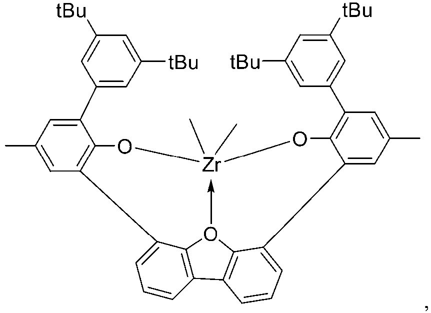 M4;
The compound (labeled as M5) was synthesized according to Example 4 in patent document CN202010793023.8 (CN111909196B), and its chemical structural formula is shown as follows: 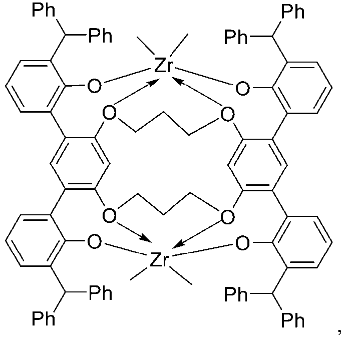 M5;
MMAO, a 7% aluminum solution, purchased from Nouryon;
Triisobutylaluminum-hexane solution, with a concentration of 1mol/L, purchased from Inno-Chem;
N,N-Dimethylanilinium tetra(pentafluorophenyl)borate, 99%, purchased from Inno-Chem, dissolved in toluene for use, labeled as B1.
tert-Butylperoxy-2-ethylhexylcarbonate, purchased from AkzoNobel, with a purity of >95%;
Triallyl isocyanurate, purchased from Acros, with a purity of 98%;
γ-Methacryloxy propyl trimethoxysilane, purchased from Aladdin, with a purity of 95%;
γ-(2,3-Epoxypropoxy)propyltrimethoxysilane, purchased from Aladdin, with a purity of 95%;
Bis[2,4-di-tert-butylphenyl] pentaerythritol diphosphite, purchased from Acros, with a purity of 95%;
1,1-Bis(tert-butylperoxy)-3,3,5-trimethylcyclohexane, purchased from Acros, with a purity of 95%;
Trimethylolpropane triacrylate, purchased from Aladdin, with a purity of 98%;
tert-Amylperoxy carbonate, purchased from Ark, with a purity of 95%;
Antioxidant 1076, n-octadecyl-β-(3,5-di-tert-butyl-4-hydroxyphenyl)-propionate purchased from Rianlon New Materials Co., Ltd., industrial grade;
Antioxidant 1010, pentaerythritol tetra[β-(3,5-di-tert-butyl-4-hydroxyphenyl)propionate], purchased from Rianlon New Materials Co., Ltd., industrial grade.

### <Test Method>

(1) In the following examples and comparative examples, the melting peak temperature (Tₘ) and melting enthalpy of the obtained polymers were tested using DSC, employing data obtained from the second heating cycle, with a heating and cooling rate of 10 °C/min. The melting range width is defined as the difference between the temperature at which the polymer is completely melted and the temperature at which melting begins, that is, the difference between T_{endset} and Tₒₙₛₑₜ.
(2) In the following examples and comparative examples, the SSA measurement of the obtained polymers was conducted using DSC. Specifically, in the first cycle, the temperature was raised to 150°C, maintained for 1 minute, and then lowered to -50°C; in the second cycle, the temperature was raised to 120°C, maintained for 5 minutes, and then lowered to -50°C; in the third cycle, the temperature was raised to 112.5°C, maintained for 5 minutes, and then lowered to -50°C; the process of temperature elevation and maintenance for 5 minutes followed by temperature reduction was repeated for the fourth cycle (i.e., during the temperature elevation in the fourth cycle, the temperature was raised at intervals of 7.5°C to a maximum of 105°C and maintained for 5 minutes before cooling down to -50°C), the fifth cycle (i.e., during the temperature elevation in the fifth cycle, the temperature was raised at intervals of 7.5°C to a maximum of 97.5°C and maintained for 5 minutes before cooling down to -50°C), the sixth cycle, and so on, until the temperature reached -40°C, thus crystallizing in each temperature interval. In the final cycle, the temperature was raised to 150°C at a rate of 10°C/min, and the heat capacity was measured. dH(90) represents the sum of the melting enthalpies above 90°C, and dH(100) represents the sum of the melting enthalpies above 100°C.
(3) In the following examples and comparative examples, the density of the obtained polymers was tested using a densitometer; the sample pieces to be tested were cut from the lamination plate, and the density was tested using a densitometer Mettler XS204, employing the impregnation method with anhydrous ethanol AR as the impregnation liquid; the test environment temperature was 23°C±2°C, and the test temperature required internal calibration for acquisition; the mass of the sample to be tested was >1g, with no bubbles; the mass of the sample in air and the mass of the sample in the impregnation liquid were weighed separately, and the sample density was calculated and derived using Archimedes' principle.
(4) In the following examples and comparative examples, the molecular weight, molecular weight distribution, and insertion rate of α-olefins (such as 1-octene) of the obtained polymers were determined using GPC-IR from Polymer Char at a testing temperature of 150°C. The product recovery rate exceeded 95%.
(5) In the following examples and comparative examples, the melt index (MI) of the obtained polymer was tested under the conditions of 190°C and a load of 2.16kg: taking 4-8g of granular material to be tested, setting the temperature to 190°C, the load to 2.16kg, and the standard die lip inner diameter to 2.095mm; melting the granular material in the barrel for 5 minutes followed by flowing it out of the die lip under the applied pressure and load; measuring and recording the time taken for the displacement point to move from 46mm to 20.6mm; automatically cutting the sample strip, and weighing the mass of the sample strip using a balance; and calculating the MFR or MVR, with units of g/10min and cm³/10min, respectively.

The ethylene/α-olefin copolymers in each example and comparative example were prepared on a continuous reaction platform equipped with reactors of different volumes and types. The operational steps were as follows:
The reactor was purged of impurities by continuously introducing dried solvent and operating for 2 days. Then, α-olefin comonomer, solvent, main catalyst, and co-catalyst were introduced into the reactor in sequence. Stirring was initiated, the system was heated, and ethylene monomer at 3 MPa to 9 MPa was introduced for polymerization reaction; wherein:
The reactions were conducted according to the polymerization reaction conditions shown in Tables 1 and 2, respectively (for example, by feeding specific solvents, ethylene, α-olefin comonomers, main catalysts, and co-catalysts into the reactor at a certain feed flow rate, controlling certain reaction pressure and reaction temperature, as well as adjusting the length-to-diameter ratio or cycle ratio according to the type of reactor selected);
After the obtained reaction mixture underwent subsequent processes (removal of volatile components, drying, followed by extrusion and granulation), specific ethylene/α-olefin copolymer product particles were obtained. Wherein:
   The volatile components in the reaction mixture were removed through flash evaporation; extrusion and granulation were carried out using a twin-screw extruder, with an extrusion temperature ranging from 80°C to 260°C and a screw speed of 30 rpm to 150 rpm.

The characteristic test results of the products prepared in each example and comparative example are shown in Tables 3 and 4.

**Table 1 Polymerization reaction conditions for each example and comparative example**

| | Reactor type | Length-to-diameter ratio/ cycle ratio | Reactor volume (L) | Solvent type | Solvent feed rate (kg/h) | Ethylene feed rate (kg/h) | Type of comonomer | Comonomer feed rate (kg/h) |
|---|---|---|---|---|---|---|---|---|
| Example 1 | Stirred tank reactor | 2:1 | 2 | IsoparE | 9.36 | 1.47 | 1-Hexe ne | 1.47 |
| Example 2 | Stirred tank reactor | 3:1 | 15 | C6 mixed alkanes | 81.93 | 16.67 | 1-Bute ne | 16.67 |
| Example 3 | Stirred tank reactor | 2.5:1 | 15 | IsoparE | 90.37 | 14.57 | 1-Octe ne | 14.57 |
| Example 4 | Circulating tubular reactor | 20 | 25 | Methylcycl -ohexane | 92.18 | 19.57 | 1-Bute ne | 19.57 |
| Example 5 | Circulating tubular reactor | 30 | 25 | C6 mixed alkanes | 58.15 | 21.20 | 1-Octe ne | 45.6 |
| Example 6 | Circulating tubular reactor | 40 | 25 | Hexane | 58.13 | 19.90 | 1-Octe ne | 19.90 |
| Comparative Example 1 | Circulating tubular reactor | 5 | 25 | C6 mixed alkanes | 58.15 | 21.20 | 1-Octe ne | 45.6 |
| Comparative Example 2 | Circulating tubular reactor | 100 | 25 | C6 mixed alkanes | 58.15 | 21.20 | 1-Octe ne | 45.6 |

**Table 2 Polymerization reaction conditions for each example and comparative example**

| | Type of main catalyst | Amount of main catalyst added (µmol/h) | Type of co-catalyst | Al/M | Type of organic boride | B/M | Temperature (°C) | Pressure (MPa) |
|---|---|---|---|---|---|---|---|---|
| Example 1 | M4 | 22.22 | MAO | 200 | - | - | 185 | 3 |
| Example 2 | M1 | 250 | MMAO | 500 | - | - | 142 | 6 |
| Example 3 | M3 | 200 | MMAO | 1,000 | - | - | 135 | 4 |
| Example 4 | M2 | 200 | TIBA | 5 | B1 | 1 | 120 | 9 |
| Example 5 | M5 | 375 | MMAO | 50 | - | - | 160 | 5 |
| Example 6 | M3 | 333.33 | TIBA | 3 | B1 | 3 | 170 | 10 |
| Comparative Example 1 | M5 | 375 | MMAO | 50 | - | - | 160 | 5 |
| Comparative Example 2 | M5 | 375 | MMAO | 50 | - | - | 160 | 5 |

**Table 3 Characteristic test results of polymers prepared in each example and comparative example**

| | Melting peak temperature Tm (°C) | Melting range width (°C) | dH(90) | dH(100) | Melting enthalpy (J/g) |
|---|---|---|---|---|---|
| Example 1 | 68 | 76 | 0.5 | 0 | 64 |
| Example 2 | 87 | 85 | 1.6 | 0 | 94 |
| Example 3 | 50 | 80 | 0 | 0 | 60 |
| Example 4 | 36 | 83 | 0 | 0 | 23 |
| Example 5 | 65 | 86 | 0.18 | 0 | 62 |
| Example 6 | 45 | 89 | 0.02 | 0 | 48 |
| Comparative Example 1 | 67 | 106 | 3 | 1 | 86 |
| Comparative Example 2 | 62 | 48 | 0.16 | 0 | 60 |
| Comparative Example 3 (Commercial ethylene/octene copolymer 8660) | 72 | 74 | 3 | 0 | 52 |
| Comparative Example 4 (Commercial ethylene/butene copolymer 8680) | 62 | 73 | 2.8 | 0 | 44 |

**Table 4 Characteristic test results of polymers obtained from each example and comparative example**

| | Density (g/cm³) | Mw (g/mol) | PDI | MI (g/10min) (19°C, 2.16kg) | Glass transition temperature Tg (°C) |
|---|---|---|---|---|---|
| Example 1 | 0.878 | 27,000 | 2.4 | 30 | -59 |
| Example 2 | 0.900 | 72,000 | 2.8 | 5.4 | -55 |
| Example 3 | 0.865 | 114,000 | 2.5 | 1.1 | -58 |
| Example 4 | 0.855 | 146,000 | 2.4 | 0.3 | -54 |
| Example 5 | 0.872 | 51,000 | 2.2 | 13 | -55 |
| Example 6 | 0.870 | 69,000 | 2.4 | 5.6 | -51 |
| Comparative Example 1 | 0.872 | 50,200 | 2.4 | 12.8 | -55 |
| Comparative Example 2 | 0.873 | 51,200 | 2.3 | 14 | -56 |
| Comparative Example 3 (Commercial ethylene/octene copolymer 8660) | 0.872 | 69,000 | 2.4 | 5 | -54 |
| Comparative Example 4 (Commercial ethylene/butene copolymer 8680) | 0.870 | 54,000 | 2.4 | 14 | -53 |

### Preparation of packaging adhesive film

### Example 7

1,000 g of the ethylene/α-olefin copolymer prepared in Example 1 was weighed and 6 g of tert-butylperoxy-2-ethylhexylcarbonate, 4.5 g of triallyl isocyanurate, 2 g of γ-methacryloxy propyl trimethoxysilane, 1 g of γ-(2,3-epoxypropoxy)propyltrimethoxysilane, 1 g of bis[2,4-di-tert-butylphenyl] pentaerythritol diphosphite, and 1 g of n-octadecyl-β-(3,5-di-tert-butyl-4-hydroxyphenyl)-propionate were added to it.

The above-mentioned raw materials were heated to 50°C and mixed evenly for 3 hours to obtain a packaging adhesive film composition. The resulting composition was then subjected to extrusion and granulation, casting into film, followed by cooling, slitting, and winding processes in a screw extruder. The extruder parameters were adjusted as follows: the temperatures from the feeding port to the die were set at 80°C, 90°C, 90°C, 90°C, 90°C, 95°C, 95°C, and 95°C; the screw speed was 45 rpm; the haul-off speed was 0.7 rpm; and the winding speed was 1.3 rpm. A solar cell packaging adhesive film was thus prepared, with a film thickness of 0.6 mm.

### Example 8

1,000g of the ethylene/α-olefin copolymer prepared in Example 2 was weighed and 9g of 1,1-bis(tert-butylperoxy)-3,3,5-trimethylcyclohexane, 2g of tert-amylperoxy carbonate, 4g of trimethylolpropane triacrylate, 2g of γ-methacryloxy propyl trimethoxysilane, 1g of γ-(2,3-epoxypropoxy)propyltrimethoxysilane, 0.1g of antioxidant 1076, and 1g of antioxidant 1010 were added to it.

The above-mentioned raw materials were heated to 50°C and mixed evenly for 3 hours to obtain a packaging adhesive film composition. The resulting mixture was then subjected to extrusion and granulation, casting into film, followed by cooling, slitting, and winding processes in a screw extruder. The extruder parameters were adjusted as follows: the temperature from the feeding port to the die were set at 80°C, 90°C, 90°C, 90°C, 90°C, 95°C, 95°C, and 95°C, the screw speed was 45 rpm, the haul-off speed was 0.7 rpm, and the winding speed was 1.3 rpm. A solar cell packaging adhesive film was thus prepared, with a film thickness of 0.6 mm.

### Example 9

The preparation process of the packaging adhesive film for solar cells followed Example 7, with the difference being that the ethylene/α-olefin copolymer weighed was the ethylene/α-olefin copolymer prepared in Example 3. The remaining operation procedures were the same as in Example 7.

### Example 10

The preparation process of the packaging adhesive film for solar cells followed Example 7, with the difference being that the ethylene/α-olefin copolymer weighed was the ethylene/α-olefin copolymer prepared in Example 4. The remaining operation procedures were the same as in Example 7.

### Example 11

The preparation process of the packaging adhesive film for solar cells followed Example 7, with the difference being that the ethylene/α-olefin copolymer weighed was the ethylene/α-olefin copolymer prepared in Example 5. The remaining operation procedures were the same as in Example 7.

### Example 12

The preparation process of the packaging adhesive film for solar cells followed Example 7, with the difference being that the ethylene/α-olefin copolymer weighed was the ethylene/α-olefin copolymer prepared in Example 6. The remaining operation procedures were the same as in Example 7.

### Comparative Example 5

The preparation process of the packaging adhesive film for solar cells followed Example 7, with the difference being that the ethylene/α-olefin copolymer weighed was the ethylene/α-olefin copolymer prepared in Comparative Example 1. The remaining operation procedures were the same as in Example 7.

In the experiment, it was observed that during the adhesive film winding process, the number of crystal spots on the film increased significantly, making it difficult to form a film and failing to meet the usage requirements.

### Comparative Example 6

The preparation process of the packaging adhesive film for solar cells followed Example 7, with the difference being that the ethylene/α-olefin copolymer weighed was the ethylene/α-olefin copolymer prepared in Comparative Example 2. The remaining operation procedures were the same as in Example 7.

### Comparative Example 7

The preparation process of the packaging adhesive film for solar cells followed Example 7, with the difference being that the ethylene/α-olefin copolymer weighed was the ethylene/α-olefin copolymer from Comparative Example 3. The remaining operation procedures were the same as in Example 7.

### Comparative Example 8

The preparation process of the packaging adhesive film for solar cells followed Example 7, with the difference being that the ethylene/α-olefin copolymer weighed was the ethylene/α-olefin copolymer from Comparative Example 4. The remaining operation procedures were the same as in Example 7.

### Example 13

The preparation process of the packaging adhesive film for solar cells followed Example 7, with the difference being that the raw materials were heated to 50°C and mixed evenly for 2 hours. The remaining operation procedures were the same as in Example 7.

### Example 14

The preparation process of the packaging adhesive film for solar cells followed Example 8, with the difference being that the raw materials were heated to 50°C and mixed evenly for 2 hours. The remaining operation procedures were the same as in Example 7.

### Example 15

The preparation process of the packaging adhesive film for solar cells followed Example 9, with the difference being that the raw materials were heated to 50°C and mixed evenly for 2 hours. The remaining operation procedures were the same as in Example 7.

### Example 16

The preparation process of the packaging adhesive film for solar cells followed Example 10, with the difference being that the raw materials were heated to 50°C and mixed evenly for 2 hours. The remaining operation procedures were the same as in Example 7.

### Example 17

The preparation process of the packaging adhesive film for solar cells followed Example 11, with the difference being that the raw materials were heated to 50°C and mixed evenly for 2 hours. The remaining operation procedures were the same as in Example 7.

### Example 18

The preparation process of the packaging adhesive film for solar cells followed Example 12, with the difference being that the raw materials were heated to 50°C and mixed evenly for 2 hours. The remaining operation procedures were the same as in Example 7.

### Comparative Example 9

The preparation process of the packaging adhesive film for solar cells followed Comparative Example 5, with the difference being that the raw materials were heated to 50°C and mixed evenly for 2 hours.

In the experiment, it was observed that during the adhesive film winding process, the number of crystal spots on the film increased significantly, making it difficult to form a film and failing to meet the usage requirements.

### Comparative Example 10

The preparation process of the packaging adhesive film for solar cells followed Comparative Example 6, with the difference being that the raw materials were heated to 50°C and mixed evenly for 2 hours.

### Comparative Example 11

The preparation process of the packaging adhesive film for solar cells followed Comparative Example 7, with the difference being that the raw materials were heated to 50°C and mixed evenly for 2 hours.

### Comparative Example 12

The preparation process of the packaging adhesive film for solar cells followed Comparative Example 8, with the difference being that the raw materials were heated to 50°C and mixed evenly for 2 hours.

According to the standards of the China Photovoltaic Industry Association (CPIA) and ASTM D2765, the crosslinking degree of the packaging adhesive film prepared as above was evaluated.

The encapsulation agent films (packaging adhesive films for solar cell) obtained from the above Examples and Comparative Examples were cut into a size of 10cm×10cm, and then vacuum laminated at 150°C for 20 minutes (maintaining vacuum for 5 minutes/applying pressure for 1 minute/releasing pressure for 14 minutes), thus obtaining the cross-linked samples for testing.

The cross-linked samples to be tested were cut into appropriate sizes, and 0.5 g of the samples were weighed on a 200-mesh wire cage. These samples were dissolved under reflux in xylene for 5 hours. Afterwards, they were dried in a vacuum oven. The weights before and after reflux were compared to measure the crosslinking degree of each sample. The crosslinking degrees of the packaging adhesive films for solar cells obtained in each example and comparative example are shown in Table 5.

**Table 5 Crosslinking degree data of packaging adhesive films in various Examples and Comparative Examples**

| Number | Crosslinking degree /% |
|---|---|
| Example 7 | 93.2 |
| Example 8 | 93.3 |
| Example 9 | 94.1 |
| Example 10 | 93.6 |
| Example 11 | 94.1 |
| Example 12 | 93.5 |
| Comparative Example 5 | 80.5 |
| Comparative Example 6 | 89.2 |
| Comparative Example 7 | 88.2 |
| Comparative Example 8 | 86.3 |
| Example 13 | 90.4 |
| Example 14 | 90.6 |
| Example 15 | 91.2 |
| Example 16 | 89.9 |
| Example 17 | 90.3 |
| Example 18 | 91.1 |
| Comparative Example 9 | 65 |
| Comparative Example 10 | 80.2 |
| Comparative Example 11 | 81.3 |
| Comparative Example 12 | 80.5 |

As shown in Table 5, when comparing Examples 7 to 12 with Comparative Examples 5 to 8, under the same conditions of mixing time for the ethylene/α-olefin copolymer and auxiliary agents during the film formation process, the ethylene/α-olefin copolymer described in the present application can enhance the crosslinking degree of photovoltaic adhesive film products. When comparing Examples 13 to 18 with Comparative Examples 9 to 12, under the same conditions of mixing time for the ethylene/α-olefin copolymer and auxiliary agents during the film formation process, the ethylene/α-olefin copolymer described in the present application shortens the mixing time with auxiliary agents during the film formation process while still maintaining a relatively high crosslinking degree, exceeding the 85% required for photovoltaic adhesive films and outperforming the ethylene/α-olefin copolymer in the Comparative Examples.

Therefore, the ethylene/α-olefin copolymer described in the present application can shorten the mixing time with auxiliary agents and improve processing efficiency; at the same time, it can maintain a high degree of crosslinking. This is because the melting range of the ethylene/α-olefin copolymer described in the present application is relatively wide, which facilitates the migration of auxiliary agents at lower temperatures. It is beneficial for auxiliary agents to migrate from the surface of particles to the interior of particles, thus achieving a higher degree of crosslinking at the same mixing time, or meeting the crosslinking requirements even with a shorter mixing time.

The examples of the present application have been described above. The above description is exemplary and not exhaustive, and is not limited to the disclosed examples. Many modifications and variations are apparent to those ordinary skilled in the art without departing from the subject of the present application.

## Claims

1. An ethylene/α-olefin copolymer, wherein the ethylene/α-olefin copolymer has the following characteristics:
(a) a melting peak temperature ranging from 30°C to 90°C and a melting range width ranging from 75°C to 90°C, as measured by differential scanning calorimeter (DSC); and
(b) dH(90) and dH(100) as measured by successive self-nucleation/annealing (SSA) using a differential scanning calorimetry, wherein 0 ≤ dH(90) ≤ 2J/g and dH(100) = 0.

2. The ethylene/α-olefin copolymer according to claim 1, wherein the ethylene/α-olefin copolymer further has the following characteristics:
(c) a density ranging from 0.850 g/cm³ to 0.905g/cm³; and
(d) a weight-average molecular weight ranging from 20,000 g/mol to 150,000 g/mol, and a polymer dispersity index (PDI) ranging from 2.3 to 3.

3. The ethylene/α-olefin copolymer according to claim 1, wherein the ethylene/α-olefin copolymer has a melting enthalpy ranging from 20 J/g to 100 J/g.

4. The ethylene/α-olefin copolymer according to claim 1, wherein the ethylene/α-olefin copolymer has a melt index (MI) ranging from 0.1 g/10min to 30g/10min under conditions of 190°C and a load of 2.16kg.

5. The ethylene/α-olefin copolymer according to claim 1, wherein the ethylene/α-olefin copolymer has a glass transition temperature (Tg) ranging from -65°C to -30°C.

6. The ethylene/α-olefin copolymer according to claim 1, wherein in the ethylene/α-olefin copolymer, the α-olefin is a C3-C20 olefin or a mixture thereof.

7. The ethylene/α-olefin copolymer according to claim 6, wherein the α-olefin is one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, and 1-eicosene.

8. The ethylene/α-olefin copolymer according to claim 1, wherein the ethylene/α-olefin copolymer is a product obtained by solution polymerization reaction of ethylene with one or more α-olefins in the presence of a catalyst and optionally hydrogen as a chain transfer agent.

9. The ethylene/α-olefin copolymer according to claim 8, wherein the solution polymerization reaction is carried out in one or more polymerization reactors;
optionally, the polymerization reactor is one or more of a non-stirred or stirred cylindrical container, a tank-shaped container, and a circulation loop reactor; and
optionally, a length-to-diameter ratio of the cylindrical container ranges from 2:1 to 3:1, a length-to-diameter ratio of the tank-shaped container ranges from 2:1 to 3:1, and a cycle ratio of the circulation loop reactor ranges from 20 to 40.

10. The ethylene/α-olefin copolymer according to claim 9, wherein during the solution polymerization reaction, the catalyst comprises a main catalyst and a co-catalyst.

11. The ethylene/α-olefin copolymer according to claim 10, wherein the main catalyst is a homogeneous catalyst selected from metallocene catalysts or non-metallocene catalysts.

12. The ethylene/α-olefin copolymer according to claim 10, wherein the co-catalyst is one or more of aluminoxane, alkyl aluminum compound, and alkylaluminum chloride, or a composition comprising one or more of aluminoxane, alkyl aluminum compound, and alkylaluminum chloride, in combination with one or more organic borides;
optionally, the aluminoxane is selected from the group consisting of methylaluminoxane and modified methylaluminoxane;
optionally, the alkyl aluminum compound is selected from the group consisting of triethylaluminum, triisobutylaluminum, and trioctylaluminum;
optionally, the alkylaluminum chloride is selected from the group consisting of diethylaluminum chloride, sesquiethylaluminum chloride, and aluminium ethyl dichloride; and
optionally, the organic boride is selected from the group consisting of triphenylmethylium tetrakis(perfluorophenyl)borate, tri(pentafluorophenyl)borane, N,N-dimethylanilinium tetra(pentafluorophenyl)borate, dioctadecylmethylamine tetra(pentafluorophenyl)borate, and di(hydrogenated tallow) methyl amine tetra(pentafluorophenyl)borate.

13. The ethylene/α-olefin copolymer according to claim 8, wherein the solution polymerization reaction is carried out at 2 MPa to 10 MPa, optionally 2 MPa to 5 MPa.

14. Application of the ethylene/α-olefin copolymer according to any one of claims 1 to 13 in the field of photovoltaic packaging adhesive film.

15. A packaging adhesive film composition for solar cells, comprising: the ethylene/α-olefin copolymer according to any one of claims 1 to 13, and optionally, an auxiliary agent;
optionally, the auxiliary agent is one or more selected from the group consisting of a crosslinking agent, a co-crosslinking agent, a coupling agent, and an antioxidant.
